# EUROPEAN PATENT APPLICATION

(11) **EP 4 831 545 A1**
(43) Date of publication of application: **28.10.2026**
(21) Application number: 25171776.5
(22) Date of filing: 22.04.2025
(51) Int. Cl.: F24D 3/18, F24F 5/00, F25B 21/02, F25B 49/00, H10N 10/17, H10N 19/00, F25B 29/00

(54) **THERMOELECTRIC MODULE, THERMOELECTRIC SYSTEM AND BUILDING SERVICES ENGINEERING SYSTEM**

(71) Applicant: AlHallami, Omran, Abu Dhabi (AE)
(72) Inventor: AlHallami, Omran, Abu Dhabi (AE)
(74) Representative: Keller Schneider Patent- und Markenanwälte AG

(57) **Abstract**

The invention relates to a thermoelectric module (1, 1', 1"). The thermoelectric module comprises two Peltier elements (2', 2"), wherein each Peltier element of the two Peltier elements (2', 2") respectively comprises a first Peltier-element side (7', 8') and a second Peltier-element side (7", 8") and wherein each Peltier element of the two Peltier elements (2', 2") respectively comprises a first terminal (12', 13') and a second terminal (12", 13") for electrically connecting the respective Peltier element to a direct-current power supply. The thermoelectric module further comprises three channel structures (3', 3", 3"'), wherein each channel structure of the three channel structures (3', 3", 3‴) respectively comprises a first channel-structure side (4', 5', 6') and a second channel-structure side (4", 5", 6"), and wherein each channel structure of the three channel structures (3', 3", 3‴) respectively comprises an inlet (9', 10', 11'), an outlet (9", 10", 11") and a tube (15) between the inlet (9', 10', 11') and the outlet (9", 10", 11"), with the tube (15) being embodied such that it provides a path through which a fluid may flow between the inlet (9', 10', 11') and the outlet (9", 10", 11"). The two Peltier elements (2', 2") and the three channel structures (3', 3", 3‴) are arranged such that the second channel-structure side (4") of a first channel structure (3') of the three channel structures extensively contacts the first Peltier-element side (7') of a first Peltier element (2') of the two Peltier elements, such that the first channel-structure side (5') of a second channel structure (3") of the three channel structures extensively contacts the second Peltier-element side (7") of the first Peltier element (2'), such that the second channel-structure side (5") of the second channel structure (3") extensively contacts the first Peltier-element side (8') of a second Peltier element (2") of the two Peltier elements, and such that the first channel-structure side (6') of a third channel structure (3‴) of the three channel structures extensively contacts the second Peltier-element side (8") of the second Peltier element (2"). The outlet (9") of the first channel structure (3') is connected through a connection tube (14) to the inlet (11') of the third channel structure (3‴). The invention further relates to a thermoelectric module and to a building services engineering system.

## Description

### Technical field

The invention relates to a thermoelectric module, to a thermoelectric system for a building services engineering system and to a building services engineering system.

### Background art

Modern buildings are provided with amenities such as sanitary systems, heating, ventilation and air conditioning (HVAC) systems and other home appliance systems. Such systems typically require extensive control and, especially in case of large buildings such as hotels or commercial buildings, rather expensive and bulky components such as chillers.

In a typical case, such modern buildings comprise a water boiler that provides heated water to a sanitary system; such modern buildings further often comprise chillers and air handler units for cooling rooms of the building; such modern buildings further often comprise dedicated heating systems, for example embodied in the form of radiators or surface heating. For all these different systems as known in the prior art, typically separate heating or cooling is carried out which multiplies the number of needed components and thereby increases cost, electricity consumption and complexity of a building's infrastructure.

### Disclosure of the invention

The object of the invention is to provide a heating and cooling system for buildings which mitigates at least some of the disadvantages of heating and cooling systems as known in the prior art.

The solution to the problem is defined by the features of claim 1. The invention relates to a thermoelectric module. The thermoelectric module comprises two Peltier elements, wherein each Peltier element of the two Peltier elements respectively comprises a first Peltier-element side and a second Peltier-element side and wherein each Peltier element of the two Peltier elements respectively comprises a first terminal and a second terminal for electrically connecting the respective Peltier element to a direct-current power supply. The thermoelectric module further comprises three channel structures, wherein each channel structure of the three channel structures respectively comprises a first channel-structure side and a second channel-structure side, and wherein each channel structure of the three channel structures respectively comprises an inlet, an outlet and a tube between the inlet and the outlet, with the tube being embodied such that it provides a path through which a fluid may flow between the inlet and the outlet. The two Peltier elements and the three channel structures are arranged such that the second channel-structure side of a first channel structure of the three channel structures extensively contacts the first Peltier-element side of a first Peltier element of the two Peltier elements, such that the first channel-structure side of a second channel structure of the three channel structures extensively contacts the second Peltier-element side of the first Peltier element, such that the second channel-structure side of the second channel structure extensively contacts the first Peltier-element side of a second Peltier element of the two Peltier elements, and such that the first channel-structure side of a third channel structure of the three channel structures extensively contacts the second Peltier-element side of the second Peltier element. The outlet of the first channel structure is connected through a connection tube to the inlet of the third channel structure.

Peltier elements use the Peltier effect to create a heat flux at the junction of two different types of materials in response to a voltage applied to a first terminal and a second terminal of a Peltier element. In a Peltier element, in response to an applied voltage thermal energy flows between two sides, namely a first Peltier-element side and a second Peltier-element side, of the Peltier element, with one of the two sides being cold and another of the two sides being hot. A Peltier element therefore absorbs heat from an element touching the cold side of the Peltier element and transfers it to another element that touches the hot side of the Peltier element.

Typically, a Peltier element comprises two ceramic plates for the first Peltier-element side and the second Peltier-element side. The ceramic plates may also function as electrical insulators. Between the two ceramic plates, a regularly spaced array of alternating n-type and p-type semiconductor columns may be arranged, i.e. in each row of the regularly spaced array, alternating n-type and p-type semiconductor columns may be arranged and in each column of the regularly spaced array, alternating n-type and p-type semiconductor columns may be arranged. Such neighboring n-type and p-type semiconductor columns do not touch each other.

A Peltier element may further comprise electrical conductors, often embodied as copper tabs that are arranged on the sides of the semiconductor columns that face the two ceramic plates. More specifically, all first sides of semiconductor columns as discussed below may face a first ceramic plate of the two ceramic plates, and all second sides of semiconductor columns as discussed below may face a second ceramic plate of the two ceramic plates.

At the first side of a first semiconductor column, preferentially in a corner of the regularly spaced array, a first electrical conductor may be arranged, which first electrical conductor may function as a first terminal for connecting an external direct-current power supply to the Peltier element. Electrical current may flow between the first side of the first semiconductor column and the second side of the first semiconductor column. Another electrical conductor may be arranged at the second side of the first semiconductor column; this electrical conductor may electrically connect the second side of the first semiconductor column to the second side of a neighboring second semiconductor column arranged in the same first column of the regularly spaced array as the first semiconductor column. The electrical current may next flow between the second side of the second semiconductor column and the first side of the second semiconductor column. Another electrical conductor may be arranged at the first side of the second semiconductor column; this electrical conductor may electrically connect the first side of the second semiconductor column to the first side of a neighboring third semiconductor column arranged in the same first column of the regularly spaced array as the second semiconductor column. This pattern may repeat until the last semiconductor column in the first column of the regularly spaced array is reached. The last semiconductor column in the first column may be electrically connected by an electrical conductor to a neighboring semiconductor column in a second column of the regularly spaced array. From there, the electrical conductors may be arranged similarly to the electrical conductors in the first column until a last semiconductor column in the second column of the regularly spaced array is reached: this last semiconductor column in the second column may be a neighboring semiconductor column of the first semiconductor column in the first row. The last semiconductor column in the second column may be electrically connected by an electrical conductor to a neighboring semiconductor column in a third column. This pattern may continue until a last semiconductor column in a last column of the regularly spaced array is reached; here, a last electrical conductor may function as a second terminal for connecting the external direct-current power supply to the Peltier element. Depending on how the direct-current power supply provides direct current to the Peltier element through the first terminal and the second terminal, heat flux between the first Peltier-element side and the second Peltier-element side may be controlled.

Each channel structure of the three channel structures comprises a respective tube that passes between a respective inlet and a respective outlet of said channel structure. One channel structure of the three channel structures is sandwiched between the two Peltier elements, while the other two channel structures of the three channel structures are each respectively only in contact with one Peltier element of the two Peltier elements. The three channel structures are embodied such that they extensively contact the sides of the Peltier element(s) next to which they are arranged. Through the extensive contact, heat may advantageously be transported to respectively away from the channel structures in an improved manner. The three channel structures and the two Peltier elements may be fixed to each other using suitable fixation means, for example cable ties; other forms of fixation are possible as well, however. Assembly of the thermoelectric module advantageously may therefore be carried out in a simple manner.

In terms of material choice, each channel structure of the three channel structures is preferentially formed using a thermally conductive material, in particular aluminum or copper. Besides the tube that passes within the channel structure and the inlet and outlet, each channel structure may otherwise be built such that no further hollow spaces exist in the respective channel structure. For each channel structure, the inlet and outlet may be provided in the form of suitable nozzles; alternatively, the inlet and outlet may be provided in the form of two openings in the channel structure, through which two openings the respective tube may be reached from outside the channel structure. Each channel structure may be made of material that is compatible with a fluid that may flow through the respective tube of the channel structure. Through the thermally conductive material of the channel structure, heat may advantageously be transported to respectively away from the fluid in the tube. To facilitate heating or cooling of the fluid in the tube, the tube of each channel structure is preferentially routed through the channel structure in a spatially distributed manner such that all areas of the two channel-structure sides of each channel structure are preferentially close to the tube. As described further below, the tube of each channel structure may preferentially be meander-shaped.

The first channel structure and the third channel structure of the three channel structures, i.e. the two channel structures that each only extensively contact one Peltier element, are fluidly connected to one another through a connection tube. Fluid that enters the first channel structure at the inlet of the first channel structure may therefore first pass through the tube of the first channel structure to the outlet of the first channel structure, from the outlet of the first channel structure through the connection tube to the inlet of the third channel structure and from the inlet of the third channel structure through the tube of the third channel structure to the outlet of the third channel structure. Fluid that enters the second channel structure, i.e. the channel structure that is sandwiched between the two Peltier elements, at the inlet of the second channel structure may pass through the tube of the second channel structure to the outlet of the second channel structure. Each channel structure may be configured such that their respective input and output may be exchanged, i.e. the respective channel structure's input may become the output and the respective channel structure's output may become the input.

Preferentially, both Peltier elements may be controlled such that the first channel structure and the third channel structure are jointly heated or cooled by the two Peltier elements. Accordingly, if the first channel structure and the third channel structure are jointly heated by the two Peltier elements, the second channel structure is cooled by the two Peltier elements, and if the first channel structure and the third channel structure are jointly cooled by the two Peltier elements, the second channel structure is heated by the two Peltier elements.

The thermoelectric module according to the invention may therefore advantageously be connected to two different fluid systems, with a fluid of a first of the two fluid systems being cooled by the thermoelectric module and a second fluid of a second of the two fluid system being heated by the thermoelectric module. One thermoelectric module advantageously may therefore provide both cooling and heating functionality. Depending on the control of the two Peltier elements, the fluid of the first fluid system may flow through the first channel structure and the third channel structure or through the second channel structure, and the fluid of the second fluid system may flow through the second channel structure or through the first channel structure and the third channel structure.

As one thermoelectric module may therefore provide both heating and cooling of fluids in two different fluid systems that are connected to the thermoelectric module, compared to prior art systems, fewer components are therefore required and electricity consumption may be reduced. Instead of having one device for heating/cooling a fluid in a first fluid system and a separate device for heating/cooling a fluid in a second fluid system, using the thermoelectric module both fluid systems may be connected to the same thermoelectric module that may provide both heating and cooling. Advantageously, cost and complexity of heating and cooling systems in buildings may thus be substantially reduced compared to prior art solutions.

In an embodiment of the thermoelectric module according to the invention, a thermal paste is arranged between (i) the second channel-structure side of the first channel structure and the first Peltier-element side of the first Peltier element, (ii) the first channel-structure side of the second channel structure and the second Peltier-element side of the first Peltier element, (iii) the second channel-structure side of the second channel structure and the first Peltier-element side of the second Peltier element, and (iv) the first channel-structure side of the third channel structure and the second Peltier-element side of the second Peltier element.

Using a thermal paste between the channel structures and the Peltier elements, heat flow between the channel structures and the Peltier elements advantageously may be improved.

In a further embodiment of the thermoelectric module according to the invention, each channel structure of the three channel structures is embodied such that a convex hull of the respective channel structure substantially corresponds to a rectangular cuboid and such that the first channel-structure side and the second channel-structure side of the respective channel structure correspond to opposite sides of the rectangular cuboid, and the inlet and outlet of each channel structure of the three channel structures are arranged on a respective third channel-structure side of the respective channel structure.

A convex hull of a shape is the smallest convex set that contains the shape. A channel structure whose convex hull substantially corresponds to a rectangular cuboid therefore has a first channel-structure side and a second channel-structure side that are both substantially flat surfaces, with the first channel-structure side and the second channel-structure side in particular being opposite surfaces of the rectangular cuboid. The inlet and outlet of each channel structure may be arranged at a third channel-structure side of the respective channel structure. The two Peltier elements may preferentially be sized such that the two Peltier-element sides, in particular embodied as ceramic plates, have a substantially same size and form as the channel-structure sides of the three channel structures. Advantageously, an extensive contact between the channel structures and the Peltier elements may thus be provided, in turn improving heat flux between the channel structures and the Peltier elements.

In a further embodiment of the thermoelectric module according to the invention, the tube of each channel structure of the three channel structures is (i) meander-shaped and (ii) within the convex hull of the respective channel structure, and each channel structure of the three channel structures is made of a thermally conductive material, in particular aluminum or copper.

A meander-shaped tube in a channel structure whose convex hull substantially corresponds to a rectangular cuboid may be arranged as follows: starting from the inlet of the channel structure at the third channel-structure side, the tube may be arranged substantially parallel to the first channel-structure side and the second channel-structure side; when the tube comes close to a fourth channel-structure side of the channel structure, which fourth channel-structure side is opposite the third channel-structure side, the tube may be bent and be then arranged substantially parallel to the third channel-structure side and the fourth channel-structure side; after a short distance, the tube may be bent again and be then arranged again substantially parallel to the first channel-structure side and the second channel-structure side; when the tube comes close to the third channel-structure side, the tube may be bent and be then arranged substantially parallel to the third channel-structure side and the fourth channel-structure side; this pattern may be continued until the meandering tube reaches the outlet of the respective channel structure.

By having a meander-shaped tube, an improved heat exchange between (i) a fluid that may flow through the tube and (ii) the Peltier element(s) is thus possible.

According to a second aspect, the invention relates to a thermoelectric system for heating and cooling, in particular for a building services engineering system. The thermoelectric system comprises at least one thermoelectric module according to the invention, a control unit, and a direct-current power supply. The direct-current power supply is configured to be electrically connected to each thermoelectric module of the at least one thermoelectric module through the two first terminals and the two second terminals of the respective thermoelectric module, and the control unit and the direct-current power supply are embodied such that the electric current supplied to the at least one thermoelectric module by the direct-current power supply may be controlled by the control unit.

As the thermoelectric system is designed for a building services engineering system, the dimensions of the channel structures and the Peltier elements of each thermoelectric module are adapted to typical dimensions of piping systems encountered in such building services engineering systems.

A building services engineering system that is installed in a building is designed to provide the building with typical amenities such as a sanitation subsystem or such as a heating, ventilation and air conditioning (HVAC) subsystem or such as a home appliance subsystem. Through a building services engineering system, room temperatures in rooms of the building may be controlled, or water temperature in showers may be controlled etc.

Building services engineering systems that are installed in large residential buildings, or large commercial buildings or hotels nowadays often comprise chillers, often installed on the rooftop of such buildings. Chillers are machines that remove heat from a fluid, typically termed coolant, often through vapor-compression cycles or other known refrigeration cycles. As fluid that circulates in such chillers, often water mixed with ethylene glycol is used. After being cooled by the chiller, the cooled fluid is typically distributed to heat exchangers in air handlers or other suitable devices that are installed in rooms of the building to cool the air in said rooms. In these heat exchangers, the fluid heats up again and is then transported back to the chiller to cool it down again. Chillers are typically large, bulky and expensive machines.

Building services engineering systems that are installed in buildings further typically comprise a sanitation subsystem. A sanitation subsystem typically comprises piping to provide and remove cold and/or hot water to/from showers, sinks, toilets, kitchen appliances etc. Such sanitation subsystems often comprise water boilers in which water is kept at a predefined high temperature.

By using a thermoelectric system according to the second aspect of the invention, which thermoelectric system comprises at least one thermoelectric module according to the invention, building services engineering systems may advantageously be simplified. Instead of for example needing separate chillers and water boilers, advantageously only thermoelectric modules may be employed as such thermoelectric modules may provide both cooling and heating functionality. Cost and complexity of building services engineering systems may thus advantageously be reduced by using a thermoelectric system according to the second aspect of the invention. As the thermoelectric module(s) of the thermoelectric system simultaneously may provide both heating and cooling, electricity consumption may be reduced: instead of electrically powering separate devices for heating/cooling fluids in two subsystems, electrical power only needs to be provided to the thermoelectric module(s) of the thermoelectric system that is/are connected to the respective two subsystems.

Devices for carrying out vapor-compression cycles as known in the prior art typically comprise moving parts, which moving parts may wear out over time and are in general susceptible to being damaged. As the thermoelectric module(s) of the thermoelectric system comprise no moving parts, compared to prior-art solutions for heating and cooling, system reliability may thus be improved and system lifetime may be extended. In case of a plurality of thermoelectric modules, reliability of the thermoelectric system is further improved compared to prior-art solutions of heating and cooling: even if the Peltier elements of one thermoelectric module of the plurality of thermoelectric modules experience problems, for example, heating and cooling of the entire thermoelectric system may only be gradually impacted. In comparison, if a centrally installed chiller of a building or a water boiler installed in a building as known in the prior art experience a problem, for example, cooling of an entire building or heating of water for sanitary purposes for the entire building may no longer be possible.

Due to the modular structure of the thermoelectric modules that are part of the thermoelectric system, a high degree of flexibility may be provided. Thermoelectric modules may in particular be fluidly connected to one another: the outlet of a third channel structure of a first thermoelectric module may be connected to an input of a first channel structure of a second thermoelectric module, for example; other interconnections between thermoelectric modules are possible as well. Using such thermoelectric modules as part of the thermoelectric system, the thermoelectric system is advantageously highly customizable and may be easily adapted to different building services engineering systems. By using the thermoelectric system in a building services engineering system, advantageously components such as chillers or water boilers may be replaced or supported. More generally, any currently used system in a building services engineering system that is used for heating or cooling a fluid may be replaced or supported by thermoelectric modules according to the invention. Depending on the type of fluid, the thermoelectric modules may need to be built with different materials that are compatible with the respective fluids; further depending on the type of heating or cooling requirements and the structure of the building in which the building services engineering system is installed, different modular arrangements of thermoelectric modules may be required.

The direct-current power supply may be embodied as a single central power supply for all thermoelectric modules of the thermoelectric system. Alternatively, the direct-current power supply may comprise a plurality of direct-current power supply units, with each of the plurality of direct-current power supply units potentially being electrically connected to a specific group of thermoelectric modules. Similarly, the control unit may be embodied as a single central control unit. Alternatively, the control unit may comprise a plurality of control subunits, with each of the plurality of control subunits potentially controlling different direct-current power supply units or the central power supply. A control subunit may be installed in each apartment of a building, for example; control subunits may also be installed in different rooms of such an apartment. The control unit or the control subunits may be embodied such that they comprise a physical interface, e.g. a slider, for setting a temperature target, or the control unit or the control subunit(s) may comprise a wireless interface for receiving instructions from a wirelessly connected device, e.g. embodied as a smartphone.

The direct-current power supply may comprise an AC-to-DC power converter, which AC-to-DC power converter may be electrically connectable to the mains electricity system. For larger buildings and a single central power supply, the AC-to-DC power converter of the direct-current power supply may also be such that it is electrically connectable to a different AC power supply that may supply more power than the mains electricity system.

As heating and cooling by the thermoelectric modules is controlled by the voltages that are applied to their respective two terminals, the single control unit or the plurality of control subunits are configured such that depending on a desired amount of heating and cooling, the single central power supply or the plurality of direct-current power supply units are suitably controlled. The thermoelectric system may therefore advantageously enable a highly customizable and local control of heating and cooling in a building services engineering system.

In an embodiment of the thermoelectric system according to the second aspect of the invention, the control unit and the direct-current power supply are embodied such that for each thermoelectric module of the at least one thermoelectric module, the electric current supplied to the respective thermoelectric module may be independently controlled by the control unit.

In a further embodiment of the thermoelectric system according to the second aspect of the invention, the control unit and the direct-current power supply are embodied such that for each thermoelectric module of the at least one thermoelectric module, the electric current supplied to the two Peltier elements of the respective thermoelectric module may be independently controlled by the control unit for each of the two Peltier elements.

According to a third aspect, the invention relates to a building services engineering system installed in a building, wherein the building services engineering system comprises 1) a primary subsystem, 2) a secondary subsystem and 3) a thermoelectric system according to the second aspect of the invention, with the direct-current power supply being electrically connected to the at least one thermoelectric module of the thermoelectric system, wherein the primary subsystem comprises a) a first pipe with a first pipe inlet and with a first pipe outlet and b) a second pipe with a second pipe inlet and with a second pipe outlet, wherein the secondary subsystem comprises a) a third pipe with a third pipe inlet and with a third pipe outlet and b) a fourth pipe with a fourth pipe inlet and with a fourth pipe outlet. The first pipe, the second pipe, the third pipe and the fourth pipe are either connected 1) at the first pipe outlet to the inlet of the first channel structure of a thermoelectric module of the thermoelectric system, at the second pipe inlet to the outlet of the third channel structure of the thermoelectric module, at the third pipe outlet to the inlet of the second channel structure of the thermoelectric module and at the fourth pipe inlet to the outlet of the second channel structure of the thermoelectric module, or connected 2) at the first pipe outlet to the inlet of the second channel structure of a thermoelectric module of the thermoelectric system, at the second pipe inlet to the outlet of the second channel structure of the thermoelectric system, at the third pipe outlet to the inlet of the first channel structure of the thermoelectric module and at the fourth pipe inlet to the outlet of the third channel structure of the thermoelectric module. A primary subsystem fluid flowing through the first pipe has a first temperature at the first pipe outlet and a secondary subsystem fluid flowing through the third pipe has a third temperature at the third pipe outlet, wherein the control unit of the thermoelectric system is configured to control the direct-current power supply such that 1) the primary subsystem fluid flowing through the second pipe has a second temperature at the second pipe inlet and such that 2) the secondary subsystem fluid flowing through the fourth pipe has a fourth temperature at the fourth pipe inlet.

Before entering the thermoelectric module, a primary subsystem fluid flowing through the first pipe has a first temperature and a secondary subsystem fluid flowing through the third pipe has a third temperature.

Based upon a second temperature target value and/or a fourth temperature target value received as input, the control unit may control the direct-current power supply to optimally align the actual second temperature of the primary subsystem fluid after the thermoelectric module to the received second temperature target value and the actual fourth temperature of the secondary subsystem fluid after the thermoelectric module to the received fourth temperature target value.

Depending on the configuration of the thermoelectric system and on the first temperature and the third temperature, a received second temperature target value and a received fourth temperature target value may not be mutually compatible. In that case, the control unit may try to reach both temperature target values as closely as possible.

In case the thermoelectric system comprises a plurality of fluidly interconnected thermoelectric modules, a received second temperature target value and/or a received fourth temperature target value may also refer to temperature target values that are to be reached by the primary subsystem fluid and/or the secondary subsystem fluid after having passed through the fluidly interconnected thermoelectric modules. In that case, the control unit may control the direct-current power supply such that the plurality of fluidly interconnected thermoelectric modules together provide the desired heating and/or cooling.

If the thermoelectric system comprises a plurality of thermoelectric modules, different groups among these thermoelectric modules may be formed that are fluidly connected to different subsystems of the building services engineering system. N thermoelectric modules, N being a natural number greater than or equal to two, of the plurality of thermoelectric modules may be connected to the primary subsystem, for example, while only *N-M, M* being a natural number smaller than N, of the N thermoelectric modules may be connected to the secondary subsystem, with the remaining M thermoelectric modules of the N thermoelectric modules potentially being connected to further subsystems of the building services engineering system. By suitably connecting a plurality of thermoelectric modules to the piping of the building services engineering system, different possible maximum cooling or heating requirements of different subsystems may therefore be satisfied by routing the piping of these different subsystems through different numbers of thermoelectric modules.

In case of larger buildings comprising a dedicated mechanical room, the at least one thermoelectric module and the direct-current power supply may be installed in said mechanical room. Alternatively, some thermoelectric modules and some direct-current power supply units may also be installed in a distributed manner throughout a building.

In an embodiment of the building services engineering system according to the third aspect of the invention, the primary subsystem is embodied as a sanitary subsystem and the secondary subsystem is embodied as a heating, ventilation and air conditioning (HVAC) subsystem.

HVAC subsystems are typically used to control the temperature, humidity and/or purity of air in an enclosed space.

In a further embodiment of the building services engineering system according to the third aspect of the invention, the primary subsystem fluid is embodied as water, the building services engineering system comprises a water supply piping and the water supply piping is connected to the sanitary subsystem and is configured to provide water at the first temperature to the sanitary subsystem, in particular to the first pipe inlet.

In a further embodiment of the building services engineering system according to the third aspect of the invention, the HVAC subsystem comprises an air conditioning unit, with the fourth pipe outlet being connected to the air conditioning unit to provide the secondary subsystem fluid to the air conditioning unit and with the third pipe inlet being connected to the air conditioning unit to receive the secondary subsystem fluid from the air conditioning unit, and the sanitary subsystem comprises a sanitary installation, with the second pipe outlet being connected to the sanitary installation to provide the primary subsystem fluid to the sanitary installation, wherein the control unit is configured to control the direct-current power supply such that the fourth temperature is lower than the third temperature and such that the second temperature is higher than the first temperature.

Instead of or in addition to a sanitary subsystem, other subsystems of the building services engineering may also be connected to the thermoelectric system.

In case the HVAC subsystem comprises an air conditioning unit, a thermoelectric module of the thermoelectric system may be arranged differently with respect to the air conditioning unit.

In a first way to connect the thermoelectric module to the air conditioning unit, the third pipe and the fourth pipe may be connected such to the thermoelectric module that the thermoelectric module cools the fluid flowing through the third pipe and the fourth pipe. The third pipe and the fourth pipe may be routed through a heat exchanger of the air conditioning unit, wherein a condensing coil of the air conditioning unit may also be arranged in the heat exchanger, with a refrigerant of the air conditioning unit flowing through the condensing coil. In the heat exchanger, heat may be transferred from the refrigerant of the air conditioning unit to the fluid flowing through the third pipe and the fourth pipe.

In a second way to connect the thermoelectric module to the air conditioning unit, a thermoelectric module of the thermoelectric system may be integrated more deeply in the air conditioning unit, particularly such that it replaces those components of the air conditioning unit that carry out the vapor-compression cycle. Accordingly, the thermoelectric module may be used for cooling the fluid flowing through the air conditioning unit. The thermoelectric module may be directly connected to an air handler unit of the air conditioning unit or to a different terminal device of the air conditioning unit where the air of an enclosed space is cooled by the air conditioning unit. As such an air conditioning unit no longer requires components for carrying out a vapor-compression cycle, the refrigerant of the air conditioning unit - which may also flow through the thermoelectric module - may be changed to water, or to water with additives. In case the vapor-compression cycles take place in an external chiller, by connecting the thermoelectric module(s) of the thermoelectric system in such a manner, an external chiller may no longer be required. As heating or cooling by the thermoelectric module(s) may be controlled by the applied voltage(s), such an air conditioning unit may be also used for heating a room, specifically in case the thermoelectric module(s) supply a heated fluid to the air handler unit. The thermoelectric system may therefore advantageously be easily switched between heating and cooling an enclosed space.

In a further embodiment of the building services engineering system according to the third aspect of the invention, (i) a condensing coil of the air conditioning unit through which condensing coil a refrigerant is configured to flow, (ii) the third pipe and (iii) the fourth pipe, are arranged at least partly in a heat exchanger of the air conditioning unit such that heat is transferrable in the heat exchanger from the refrigerant to the secondary subsystem fluid.

In a further embodiment of the building services engineering system according to the third aspect of the invention, the HVAC subsystem comprises an air handler unit, with the fourth pipe outlet being connected to the air handler unit to provide the secondary subsystem fluid to the air handler unit and with the third pipe inlet being connected to the air handler unit to receive the secondary subsystem fluid from the air handler unit, and the primary subsystem comprises a sanitary installation, with the second pipe outlet being connected to the sanitary installation to provide the primary subsystem fluid to the sanitary installation, wherein the control unit is configured to control the direct-current power supply such that the fourth temperature is lower than the third temperature and such that the second temperature is higher than the first temperature.

In a further embodiment of the building services engineering system according to the third aspect of the invention, the sanitary installation is embodied as a reservoir tank, in particular a water boiler.

If a building comprises a reservoir tank, water that is heated by the at least one thermoelectric module may be stored in the reservoir tank for distribution. If the building comprises a water boiler, the at least one thermoelectric module may also be used for pre-heating water before the water enters the water boiler.

In a further embodiment of the building services engineering system according to the third aspect of the invention, the primary subsystem is embodied as a HVAC subsystem and the secondary subsystem is embodied as a home appliance subsystem, wherein the HVAC subsystem comprises (i) a heating circuit distributor for a surface heating installed in the building or (ii) a radiator, with the heating circuit distributor or the radiator having a flow and a return, with the second pipe outlet being connected to the flow and with the first pipe inlet being connected to the return, and wherein the fourth pipe outlet is connected to an input of a home appliance device of the home appliance subsystem and the third pipe inlet is connected to an output of the home appliance device, wherein the control unit is configured to control the direct-current power supply such that the second temperature is higher than the first temperature and such that the fourth temperature is lower than the third temperature.

The thermoelectric system may also be used for heating a building through radiator(s) or surface heating and for providing cooled fluid to a refrigerator, in particular a modified refrigerator in which components needed for a vapor-compression cycle are removed.

In a further embodiment of the building services engineering system according to the third aspect of the invention, the home appliance device is embodied as a refrigerator.

Besides the specifically disclosed applications of the thermoelectric system in different configurations, i.e. with different primary and secondary subsystems, the thermoelectric subsystem may be employed in principle for any pair of subsystems in which one of the two subsystems requires cooling and the other of the two subsystems requires heating.

In a further embodiment of the building services engineering system according to the third aspect of the invention, the control unit is configured to receive as input a second temperature target value and/or a fourth temperature target value.

Further advantageous embodiments and combinations of features of the invention result from the following exemplary embodiments and the set of patent claims as a whole.

### Brief description of the drawings

The drawings used to illustrate the exemplary embodiments show:
Fig. 1 shows different views of a thermoelectric module; and
Fig. 2 shows a schematic embodiment of a building services engineering system.

In general, identical parts are marked with the same reference symbols in the figures.

### Detailed description of the drawings

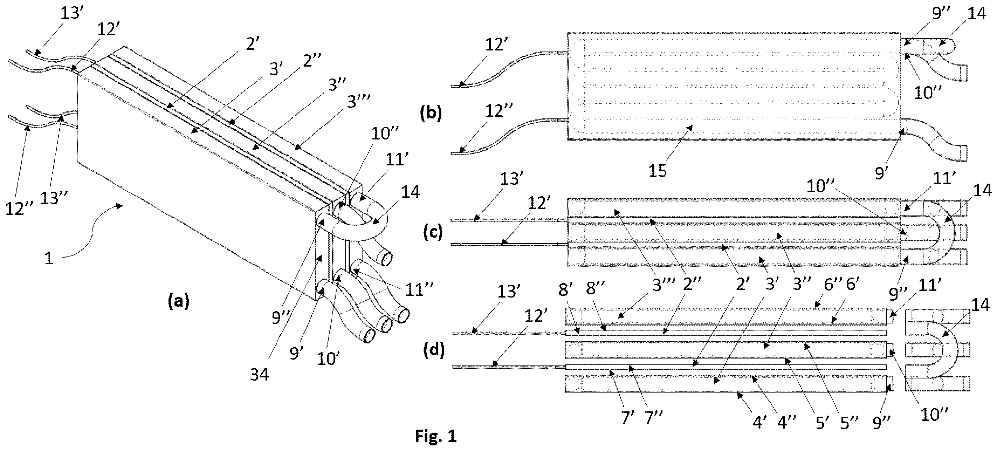

Fig. 1a shows a perspective view of a thermoelectric module 1. The thermoelectric module 1 comprises a first Peltier element 2', a second Peltier element 2", a first channel structure 3', a second channel structure 3" and a third channel structure 3"'. The second channel structure 3" is arranged between the first Peltier element 2' and the second Peltier element 2" and extensively contacts both Peltier elements 2', 2"; the first channel structure 3' only extensively contacts the first Peltier element 2', while the third channel structure 3‴ only extensively contacts the second Peltier element 2". The first Peltier element 2' comprises two terminals 12', 12" through which a voltage may be applied to the first Peltier element 2'; the second Peltier element 2" also comprises two terminals 13', 13" through which a voltage may be applied to the second Peltier element 2".

The first channel structure 3' comprises an inlet 9' and an outlet 9". As indicated in the lateral view of Fig. 1b of the thermoelectric module 1 of Fig. 1a, the inlet 9' is fluidly connected to the outlet 9" by a meander-shaped tube 15. The second channel structure 3" also comprises an inlet 10' and an outlet 10" as well as a meander-shaped tube between the inlet 10' and the outlet 10", with the tube of the second channel structure 3" being shaped similarly as the tube of the first channel structure 3'. The third channel structure 3‴ also comprises an inlet 11' and an outlet 11" as well as a meander-shaped tube between the inlet 11' and the outlet 11", with the tube of the third channel structure 3‴ being shaped similarly as the tube of the first channel structure 3'. Inlets 9', 10', 11' and outlets 9", 10", 11" are arranged at a third channel-structure side 34.

The outlet 9" of the first channel structure 3' is fluidly connected through a connection tube 14 to the inlet 11' of the third channel structure 3"'. For visual reasons, segments of pipes are shown in Fig. 1a that are attached to the inlet 9' of the first channel structure 3', to the inlet 10' of the second channel structure 3", to the outlet 10" of the second channel structure 3" and to the outlet 11" of the third channel structure 3"'. In the lateral view of Fig. 1b, the inlet 9' and the outlet 9" of the first channel structure 3', the connection tube 14 and a segment of the pipe connected to the outlet 10" of the second channel structure 3" are visible.

In Fig. 1c and Fig. 1d, views from the top of the thermoelectric module 1 of Fig. 1a are shown, with Fig. 1d corresponding to a partly expanded Fig. 1c. As visible in the expanded view of Fig. 1d, a second channel-structure side 4" of the first channel structure 3' extensively contacts a first Peltier-element side 7' of the first Peltier element 2', while a first channel-structure side 4' of the first channel structure 3' does not contact the first Peltier element 2' nor the second Peltier element 2". A first channel-structure side 5' of the second channel structure 3" extensively contacts a second Peltier-element side 7" of the first Peltier element 2'; a second channel-structure side 5" of the second channel structure 3" extensively contacts a first Peltier-element side 8' of the second Peltier element 2". A first channel-structure side 6'of the third channel structure 3‴ extensively contact a second Peltier-element side 8" of the second Peltier element 2", while a second channel-structure side 6" of the third channel structure 3‴ does not contact the first Peltier element 2' nor the second Peltier element 2".

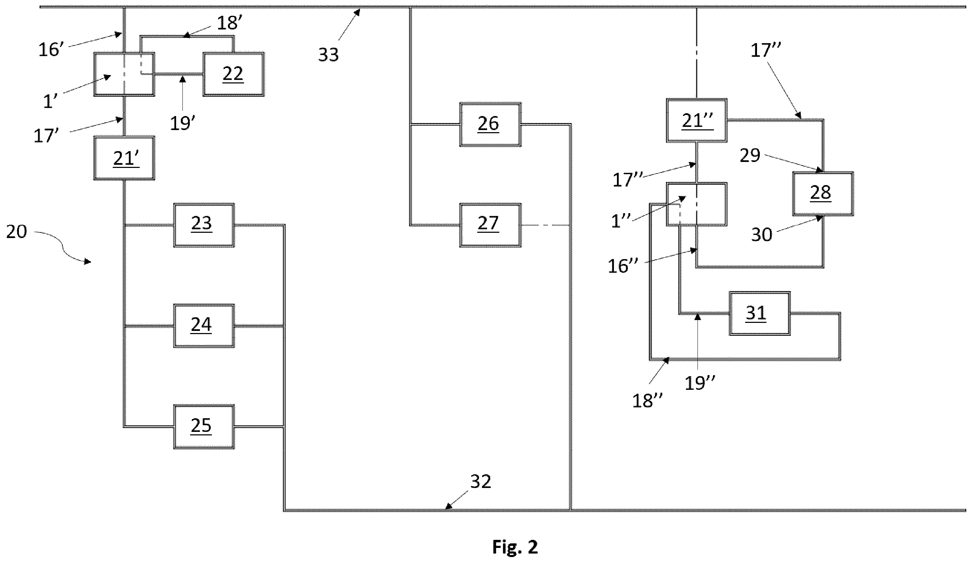

Fig. 2 shows a schematic embodiment of a building services engineering system 20. The building services engineering system 20 of Fig. 2 comprises a water supply piping 33 and two thermoelectric modules 1', 1". In Fig. 2, neither the direct-current power supply nor the control unit are shown. A first thermoelectric module 1' is connected to sanitary subsystem 23, 24, 25 and to an air conditioning unit 22. A connection between the water supply piping 33 and the sanitary subsystem 23, 24, 25 is provided through a first pipe 16' and a second pipe 17 that are connected to the first thermoelectric module 1', while a connection between the air conditioning unit 22 and the first thermoelectric module 1' is provided through a third pipe 18' and a fourth pipe 19'.

Through the fourth pipe 19', a fluid that is cooled by the first thermoelectric module 1' is provided to the air conditioning unit 22, while through the third pipe 18', a fluid that is heated up by the air conditioning unit 22 is returned to the first thermoelectric module 1'. Through the first pipe 16', water from the water supply piping 33 is provided to the first thermoelectric module 1', which first thermoelectric module 1' heats this water and provided it via the second pipe 17' to a reservoir tank 21'. From the reservoir tank 21', heated water may be provided to bathroom equipment 23 such as showers, or to a washing machine 24, or to kitchen equipment 25 such as a dishwasher. The sanitary subsystem is connected to a wastewater pipe 32.

The building services engineering system 20 of Fig. 2 comprises further parts that are not connected to thermoelectric modules 1', 1". A toilet 26 or outdoor devices 27 is fluidly arranged between the water supply piping 33 and the wastewater pipe 32.

The building services engineering system 20 of Fig. 2 comprises another reservoir tank 21" and a room heating system 28 such as 1) a heating circuit distributor for a surface heating or 2) a radiator. Such a room heating system 28 comprises a flow 29 and a return 30. A first pipe 16" is connected to the return 30 and a fluid cooled by the room heating system 28 to the second thermoelectric module 1" which heats the fluid. Through a second pipe 17", which in Fig. 2 passes through the reservoir tank 21", heated water is supplied to the flow 29 of the room heating system 28. The second thermoelectric module 1" of Fig. 2 is further connected through a first pipe 18" to a refrigerator 31 from which it receives a heated fluid; the second thermoelectric module 1" cools this fluid and provides it through a second pipe 19" to the refrigerator 31.

## Claims

1. Thermoelectric module (1, 1', 1"), comprising
1) two Peltier elements (2', 2"), wherein each Peltier element of the two Peltier elements (2', 2") respectively comprises a first Peltier-element side (7', 8') and a second Peltier-element side (7", 8") and wherein each Peltier element of the two Peltier elements (2', 2") respectively comprises a first terminal (12', 13') and a second terminal (12", 13") for electrically connecting the respective Peltier element to a direct-current power supply,
2) three channel structures (3', 3", 3"'), wherein each channel structure of the three channel structures (3', 3", 3‴) respectively comprises a first channel-structure side (4', 5', 6') and a second channel-structure side (4", 5", 6"), and wherein each channel structure of the three channel structures (3', 3", 3‴) respectively comprises an inlet (9', 10', 11'), an outlet (9", 10", 11") and a tube (15) between the inlet (9', 10', 11') and the outlet (9", 10", 11"), with the tube (15) being embodied such that it provides a path through which a fluid may flow between the inlet (9', 10', 11') and the outlet (9", 10", 11"),
wherein the two Peltier elements (2', 2") and the three channel structures (3', 3", 3‴) are arranged such that
a) the second channel-structure side (4") of a first channel structure (3') of the three channel structures extensively contacts the first Peltier-element side (7') of a first Peltier element (2') of the two Peltier elements, such that
b) the first channel-structure side (5') of a second channel structure (3") of the three channel structures extensively contacts the second Peltier-element side (7") of the first Peltier element (2'), such that
c) the second channel-structure side (5") of the second channel structure (3") extensively contacts the first Peltier-element side (8') of a second Peltier element (2") of the two Peltier elements, and such that
d) the first channel-structure side (6') of a third channel structure (3"') of the three channel structures extensively contacts the second Peltier-element side (8") of the second Peltier element (2"), and
wherein the outlet (9") of the first channel structure (3') is connected through a connection tube (14) to the inlet (11') of the third channel structure (3"').

2. Thermoelectric module (1, 1', 1") according to claim 1, wherein a thermal paste is arranged between (i) the second channel-structure side (4") of the first channel structure (3') and the first Peltier-element side (7') of the first Peltier element (2'), (ii) the first channel-structure side (5') of the second channel structure (3") and the second Peltier-element side (7") of the first Peltier element (2'), (iii) the second channel-structure side (5") of the second channel structure (3") and the first Peltier-element side (8') of the second Peltier element (2"), and (iv) the first channel-structure side (6') of the third channel structure (3"') and the second Peltier-element side (8") of the second Peltier element (2").

3. Thermoelectric module (1, 1', 1") according to claim 1 or 2, wherein each channel structure of the three channel structures (3', 3", 3"') is embodied such that
1) a convex hull of the respective channel structure substantially corresponds to a rectangular cuboid and such that
2) the first channel-structure side (4', 5', 6') and the second channel-structure side (4", 5", 6") of the respective channel structure correspond to opposite sides of the rectangular cuboid, and
wherein the inlet (9', 10', 11') and outlet (9", 10", 11") of each channel structure of the three channel structures (3', 3", 3‴) are arranged on a respective third channel-structure side (34) of the respective channel structure.

4. Thermoelectric module (1, 1', 1") according to claim 3, wherein the tube (15) of each channel structure of the three channel structures (3', 3", 3‴) is (i) meander-shaped and (ii) within the convex hull of the respective channel structure, and wherein each channel structure of the three channel structures (3', 3", 3"') is made of a thermally conductive material, in particular aluminum or copper.

5. Thermoelectric system for heating and cooling, in particular for a building services engineering system (20), the thermoelectric system comprising
1) at least one thermoelectric module (1, 1', 1") according to any one of the preceding claims,
2) a control unit, and
3) a direct-current power supply,
wherein the direct-current power supply is configured to be electrically connected to each thermoelectric module (1, 1', 1") of the at least one thermoelectric module through the two first terminals (12', 13') and the two second terminals (12", 13") of the respective thermoelectric module (1, 1', 1"), and wherein the control unit and the direct-current power supply are embodied such that the electric current supplied to the at least one thermoelectric module (1, 1', 1") by the direct-current power supply may be controlled by the control unit.

6. Thermoelectric system according to claim 5, wherein the control unit and the direct-current power supply are embodied such that for each thermoelectric module (1, 1', 1") of the at least one thermoelectric module, the electric current supplied to the respective thermoelectric module may be independently controlled by the control unit.

7. Thermoelectric system according to claim 5 or 6, wherein the control unit and the direct-current power supply are embodied such that for each thermoelectric module (1, 1', 1") of the at least one thermoelectric module, the electric current supplied to the two Peltier elements (2', 2") of the respective thermoelectric module (1, 1', 1") may be independently controlled by the control unit for each of the two Peltier elements (2', 2").

8. Building services engineering system (20) installed in a building, wherein the building services engineering system (20) comprises 1) a primary subsystem (16', 17', 21', 23, 24, 25, 16", 17", 21", 28, 29, 30), 2) a secondary subsystem (18', 19', 22, 18", 19", 31) and 3) a thermoelectric system according to any one of claims 5 to 7, with the direct-current power supply being electrically connected to the at least one thermoelectric module (1, 1', 1") of the thermoelectric system, wherein the primary subsystem comprises a) a first pipe (16', 16") with a first pipe inlet and with a first pipe outlet and b) a second pipe (17', 17") with a second pipe inlet and with a second pipe outlet, wherein the secondary subsystem comprises a) a third pipe (18', 18") with a third pipe inlet and with a third pipe outlet and b) a fourth pipe (19', 19") with a fourth pipe inlet and with a fourth pipe outlet, wherein the first pipe, the second pipe, the third pipe and the fourth pipe are either connected
• at the first pipe outlet to the inlet (9') of the first channel structure (3') of a thermoelectric module (1, 1', 1") of the thermoelectric system, at the second pipe inlet to the outlet (11") of the third channel structure (3"') of the thermoelectric module (1, 1', 1"), at the third pipe outlet to the inlet (10') of the second channel structure (3") of the thermoelectric module (1, 1', 1") and at the fourth pipe inlet to the outlet (10") of the second channel structure (3") of the thermoelectric module (1, 1', 1"), or connected
• at the first pipe outlet to the inlet (10') of the second channel structure (3") of a thermoelectric module (1, 1', 1") of the thermoelectric system, at the second pipe inlet to the outlet (10") of the second channel structure (3") of the thermoelectric system, at the third pipe outlet to the inlet (9') of the first channel structure (3') of the thermoelectric module (1, 1', 1") and at the fourth pipe inlet to the outlet (11") of the third channel structure (3‴) of the thermoelectric module (1, 1', 1"), and
wherein a primary subsystem fluid flowing through the first pipe (16', 16") has a first temperature at the first pipe outlet and a secondary subsystem fluid flowing through the third pipe (18', 18") has a third temperature at the third pipe outlet, wherein the control unit of the thermoelectric system is configured to control the direct-current power supply such that 1) the primary subsystem fluid flowing through the second pipe (17', 17") has a second temperature at the second pipe inlet and such that 2) the secondary subsystem fluid flowing through the fourth pipe (19', 19") has a fourth temperature at the fourth pipe inlet.

9. Building services engineering system (20) according to claim 8, wherein the primary subsystem is embodied as a sanitary subsystem (16', 17', 21', 23, 24, 25) and wherein the secondary subsystem is embodied as a heating, ventilation and air conditioning (HVAC) subsystem (18', 19', 22).

10. Building services engineering system (20) according to claim 9, with the primary subsystem fluid being embodied as water, wherein the building services engineering system (20) comprises a water supply piping (33) and wherein the water supply piping (33) is connected to the sanitary subsystem and is configured to provide water at the first temperature to the sanitary subsystem, in particular to the first pipe inlet.

11. Building services engineering system (20) according to claim 9 or 10, wherein the HVAC subsystem (18', 19', 22) comprises an air conditioning unit (22), with the fourth pipe outlet being connected to the air conditioning unit to provide the secondary subsystem fluid to the air conditioning unit and with the third pipe inlet being connected to the air conditioning unit to receive the secondary subsystem fluid from the air conditioning unit, and wherein the sanitary subsystem comprises a sanitary installation (21', 23, 24, 25), with the second pipe outlet being connected to the sanitary installation to provide the primary subsystem fluid to the sanitary installation, wherein the control unit is configured to control the direct-current power supply such that the fourth temperature is lower than the third temperature and such that the second temperature is higher than the first temperature.

12. Building services engineering system (20) according to claim 11, wherein (i) a condensing coil of the air conditioning unit (22) through which condensing coil a refrigerant is configured to flow, (ii) the third pipe (18') and (iii) the fourth pipe (19'), are arranged at least partly in a heat exchanger of the air conditioning unit (22) such that heat is transferrable in the heat exchanger from the refrigerant to the secondary subsystem fluid.

13. Building services engineering system (20) according to claim 9 or 10, wherein the HVAC subsystem comprises an air handler unit, with the fourth pipe outlet being connected to the air handler unit to provide the secondary subsystem fluid to the air handler unit and with the third pipe inlet being connected to the air handler unit to receive the secondary subsystem fluid from the air handler unit, and wherein the primary subsystem comprises a sanitary installation, with the second pipe outlet being connected to the sanitary installation to provide the primary subsystem fluid to the sanitary installation, wherein the control unit is configured to control the direct-current power supply such that the fourth temperature is lower than the third temperature and such that the second temperature is higher than the first temperature.

14. Building services engineering system (20) according to any one of claims 11 to 13, wherein the sanitary installation is embodied as a reservoir tank (21'), in particular a water boiler.

15. Building services engineering system (20) according to claim 8, wherein the primary subsystem is embodied as a HVAC subsystem (16", 17", 28, 29, 30) and wherein the secondary subsystem is embodied as a home appliance subsystem (18", 19", 31), wherein the HVAC subsystem comprises (i) a heating circuit distributor (28) for a surface heating (28) installed in the building or (ii) a radiator (28), with the heating circuit distributor or the radiator having a flow (29) and a return (30), with the second pipe outlet being connected to the flow and with the first pipe inlet being connected to the return, and wherein the fourth pipe outlet is connected to an input of a home appliance device (31) of the home appliance subsystem and the third pipe inlet is connected to an output of the home appliance device (31), wherein the control unit is configured to control the direct-current power supply such that the second temperature is higher than the first temperature and such that the fourth temperature is lower than the third temperature.

16. Building services engineering system (20) according to claim 15, wherein the home appliance device is embodied as a refrigerator (31).

17. Building services engineering system (20) according to any one of claims 8 to 16, wherein the control unit is configured to receive as input a second temperature target value and/or a fourth temperature target value.
